# EUROPEAN PATENT APPLICATION

(11) **EP 4 836 454 A1**
(43) Date of publication of application: **04.11.2026**
(21) Application number: 26170911.7
(22) Date of filing: 07.04.2026
(51) Int. Cl.: H04S 7/00, H03G 5/16

(54) **EVENT-BASED ADAPTIVE EQUALIZER**

(30) Priority: 01.05.2025 US 202519196197
(71) Applicant: Harman Becker Automotive Systems GmbH, 76307 Karlsbad (DE)
(72) Inventor: DAFTUAR, Rishi Kumar, 76307 Karlsbad (DE); SCHNEIDER, David Patrick, 76307 Karlsbad (DE)
(74) Representative: Kraus & Lederer PartGmbB

(57) **Abstract**

Techniques are described for equalizing audio, for example, to prevent or alleviate fatigue in response to identified audio events. In some embodiments, the techniques include processing a moving time window of an audio input to identify audio events, determining audio effects based on audio events, generating an audio output by applying the audio effects to the audio input, and producing a sound field based on the audio output.

## Description

### BACKGROUND

### Field of the Various Embodiments

This application relates to techniques for audio processing, and more specifically, to adaptively equalizing and otherwise modifying audio effects using event detection, for example, to prevent or alleviate fatigue.

### Description of the Related Art

Audio systems utilize wide varieties of techniques to achieve post processing effects for the end user experience. The effects can create an audio atmosphere, or a desired audio effect. However, effects that provide a good first impression of an audio system can cause listener fatigue over an extended period of time. For example, bright high notes can provide the impression of clarity and detail, but over time fatigue can cause a listener to consider the sound harsh or piercing. Likewise, a powerful midrange can initially provide impressive vocals, but the same powerful midrange can cause a listener to consider the sound shouty over time. A powerful bass experience can initially provide an impression of audio quality but can also become physically tiring over time.

While some products may provide a limit to prevent listening at high volume levels, existing products do not adapt to changing audio signals. Rather, the post-processing effects represent a compromise for the reproduction audio in a given audio system because the limits or effects are applied statically to every track. As a result, the audio that is produced can cause fatigue despite the volume limit. The resulting audio can also be too low in volume to provide a good impression or desired audio effect.

As the foregoing illustrates, what is needed in the art is improved techniques for audio effects processing.

### SUMMARY

One embodiment of the present disclosure sets forth a method that includes processing an audio signal to identify an audio event based on a value such as a running average that is generated based on a moving time window of the audio signal, determining one or more audio effects based on the audio event, generating an audio output by applying the one or more audio effects to an audio input, and producing a sound field based on the audio output.

At least one technical advantage of the disclosed techniques relative to the prior art is that the disclosed techniques enable adaptive modification of audio fields that change over time to provide a safe and healthy listening experience while maintaining short term punch, thus providing greater accessibility. The disclosed techniques allow for an audio system to automatically change equalization, dynamics, and other audio processing effects over time in response to different types of events, such as fatigue inducing events. As a result, the disclosed techniques do not involve a statically applied compromise but rather apply adaptive effects based on real-time audio analysis. These technical advantages represent one or more technological improvements over prior art approaches.

### BRIEF DESCRIPTION OF THE DRAWINGS

So that the manner in which the above recited features of the various embodiments can be understood in detail, a more particular description of the inventive concepts, briefly summarized above, may be had by reference to various embodiments, some of which are illustrated in the appended drawings. It is to be noted, however, that the appended drawings illustrate only typical embodiments of the inventive concepts and are therefore not to be considered limiting of scope in any way, and that there are other equally effective embodiments.
Figure 1 is a schematic diagram illustrating an audio system according to various embodiments;
Figure 2 is a diagram illustrating the operation of the audio processing application of Figure 1, according to various embodiments;
Figure 3 is a diagram illustrating the operation of the audio processing application of Figure 1, according to various embodiments;
Figure 4 is a diagram illustrating the operation of the audio processing application of Figure 1, according to various embodiments;
Figure 5 is a diagram illustrating the operation of the audio processing application of Figure 1, according to various embodiments; and
Figure 6 is a flow diagram of method steps for generating audio output based on audio events such as fatigue events, according to various embodiments.

### DETAILED DESCRIPTION

In the following description, numerous specific details are set forth to provide a more thorough understanding of the various embodiments. However, it will be apparent to one of skilled in the art that the inventive concepts may be practiced without one or more of these specific details.

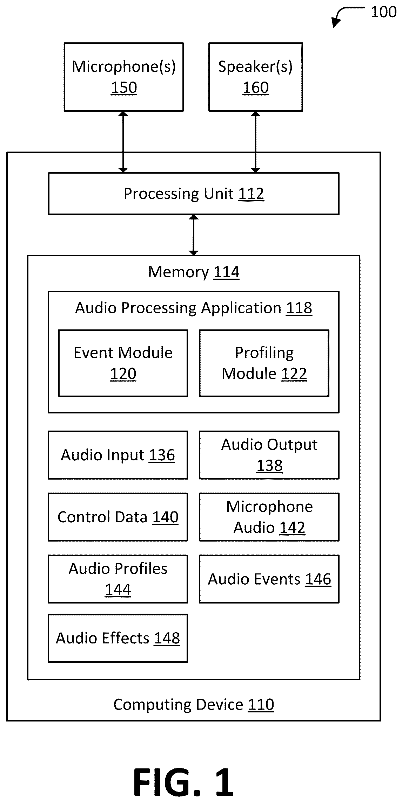

Figure 1 is a schematic diagram illustrating an audio system 100 according to various embodiments. As shown, the audio system 100 includes, without limitation, one or more computing devices 110, one or more microphones 150, and one or more speakers 160. A computing device 110 includes, without limitation, one or more processing units 112 and one or more memories 114. In various embodiments, an interconnect bus (not shown) connects the one or more processing units 112, the one or more memories 114, the microphones 150, the speakers 160, and any other components of the computing device 110. The one or more memories 114 store, without limitation, an audio processing application 118, an event module 120, a profiling module 122, an audio input 136, an audio output 138, control data 140, microphone audio 142, audio profiles 144, audio events 146, and audio effects 148. While shown as submodules of the audio processing application 118, the event module 120 and the profiling module 122 can include executable instructions that work in concert with the audio processing application 118 as submodules and/or separate software modules.

In various embodiments, the one or more computing devices 110 are included in any feasible audio system, such as a vehicle audio system, a home theater system, a soundbar and/or the like. In some embodiments, one or more computing devices 110 are included in one or more devices, such as consumer products (e.g., portable speakers, gaming, etc. products), vehicles (e.g., the head unit or amplifier of an automobile, truck, van, etc.), smart home devices (e.g., smart lighting systems, security systems, digital assistants, etc.), communications systems (e.g., conference call systems, video conferencing systems, speaker amplification systems, etc.), and so forth. In various embodiments, one or more computing devices 110 are located in various environments including, without limitation, indoor environments (e.g., living room, conference room, conference hall, home office, etc.), and/or outdoor environments, (e.g., patio, rooftop, garden, etc.). The computing device 110 is also able to provide output audio signals (e.g., audio output 138 generated using the audio processing application 118) to speaker(s) 160 or other audio devices to generate a sound field that provides various audio effects.

The one or more processing units 112 can be any suitable processor, such as a central processing unit (CPU), a graphics processing unit (GPU), an application-specific integrated circuit (ASIC), a field programmable gate array (FPGA), a digital signal processor (DSP), and/or any other type of processing unit, or a combination of different processing units, such as a CPU configured to operate in conjunction with a GPU and/or a DSP. In general, a processing unit 112 can be any technically feasible hardware unit capable of processing data and/or executing software applications.

Memory 114 can include a random-access memory (RAM) module, a flash memory unit, or any other type of memory unit or combination thereof. Processing units 112 are configured to read data from and write data to the memory 114. In various embodiments, a memory 114 includes non-volatile memory, such as optical drives, magnetic drives, flash drives, or other storage. In some embodiments, separate data stores, such as an external data stores included in a network ("cloud storage") can supplement the memory 114.

The microphones 150 include any feasible audio recording device capable of detecting and recording audio. The speakers 160 include various speakers and other audio devices for outputting audio to create the sound field or the various audio effects 148 in the vicinity of the user. In some embodiments, the speakers 160 are associated with a speaker configuration that includes speaker locations identified and stored in the memory 114. The speaker configuration indicates locations and/or orientations of the speakers 160 in a three-dimensional space and/or relative to one another and/or relative to a microphone 150, a vehicle, a vehicle seat, a gaming chair, a particular one of the speakers 160, the computing device 110, a location of a user, and/or the like.

The audio processing application 118 retrieves or otherwise identifies the speaker configuration of the speakers 160 to apply certain audio effects 148 to audio produced using the speakers 160. The audio processing application 118 identifies an audio input 136. For example, the audio processing application 118 retrieves the audio input 136 from the memory 114 and/or receives the audio input 136 over a network such as a local area network or a wide area network. In some embodiments, the audio processing application 118 processes the audio input 136 according to time frames or discrete time segments according to a running average or other moving or running time window audio process.

The audio input 136 includes any feasible signal or data that includes an audio signal. The audio input 136 includes an audio, video, multimedia, or other data file, stream, and/or the like. In some embodiments, the audio system 100 receives the audio input 136 over a network such as a local area network or a wide area network. The network can include a public and/or private network. The audio system 100 durably and/or temporarily stores the audio input 136 in the memories 114. In some embodiments, the audio processing application 118 processes the audio input 136 in discrete time chunks or segments. The audio processing application 118 segments the audio input 136 into discrete and uniformly spaced time segments according to units of time for processing. The audio processing application 118 also separates the audio input 136 into frequency bins as discussed above.

The audio output 138 is a processed version of the audio input 136, which is processed to include one or more audio effects 148. The audio effects 148 include any feasible modifications of an audio input 136 to produce any desired audio output 138. For example, audio effects 148 include equalization, dynamics processing such as compression, expansion, reduction of (and/or increasing) transients, reduction of (and/or increasing) signal saturation, volume adjustment, reverb, delay, echo, spatial effects, and/or the like. The audio processing application 118 applies the one or more audio effects 148 by modifying at least one equalizer value or parameter for equalization, performing dynamics processing, or performing volume processing, and/or the like. Accordingly, the audio processing application 118 dynamically applies one or more of equalization, dynamic equalization, compression, expansion, transient shaping, saturation, volume/gain control, clipping, or excitation (e.g., harmonic excitation) based on the audio input 136.

The event module 120 includes any feasible executable instructions that identify one or more audio events 146 based on audio signals. In various embodiments, the audio signals include the audio input 136 and/or the microphone audio 142. The audio events 146 include a number of trigger events that are mapped to one or more audio effects 148 or modification of the one or more audio effects 148. The event module 120 stores, in the memory 114, a mapping of audio events 146 to audio effects 148 and/or modifications to audio effects 148. The event module 120 stores, in the memory 114, audio events 146 including fatigue events, brightness events, clarity events, punch events, and/or the like. The fatigue events include high fatigue events (e.g., higher than a threshold fatigue score or level) and low fatigue events (e.g., lower than a threshold fatigue score or level). For example, a high fatigue event can include an event that indicates a user is likely to be fatigued by the audio or sound recently produced (e.g., within a threshold amount of time) by the audio system 100. By contrast a low fatigue event can include an event that indicates user fatigue may be waning based on the audio or sound recently produced (e.g., within a threshold amount of time) by the audio system 100. In some embodiments, a high fatigue event is mapped to an audio effect 148 modification such as a reduction in transients, a reduction of signal saturation, a reduction of one or more equalization frequency bands, and/or a volume reduction. In some embodiments, a low fatigue event is mapped to an audio effect 148 modification such as an increase in transients, an increase of signal saturation, an increase of one or more equalization frequency bands, and/or a volume increase.

In various embodiments, the event module 120 identifies one or more audio events 146 and a corresponding one or more audio effects 148 based on a time window of a threshold amount of time. The event module identifies parameters corresponding to audio input 136 for the time window, microphone audio 142 for the time window, current control data 140, audio profiles 144, previous audio events 146, time elapsed between a current time and the previous audio event 146, previous and currently applied audio effects 148, and/or the like. In some embodiments, the event module 120 identifies one or more audio events 146 and a corresponding one or more audio effects 148 and/or modifications or updates to audio effects 148. The event module 120 identifies one or more audio events 146 based on an overall peak level (e.g., for all frequencies), one or more frequency-specific peak levels (e.g., for one or more frequency bins or ranges), overall and/or frequency-specific root mean square levels, overall and/or frequency-specific signal to noise ratios, and other measures of the audio input 136 (or other audio signal) in a moving time window. In some embodiments, the event module 120 identifies one or more audio events 146 and a corresponding one or more audio effects 148 based on a decibel level of microphone audio 142 (or other audio signal). In some examples, audio events 146 correspond to frequency range (e.g., bass/mid/treble) balance events, clarity events, detail, harshness events, impact or punch events, warmth events, muddiness events, sound stage width and envelopment events, volume based equalization events, dynamic equalization events, fatiguing events, and/or the like. In some embodiments, various different audio events 146 are identified over various different time frames or durations of time from instantaneous threshold events to longer time frame events.

The profiling module 122 includes any feasible executable instructions that identify one or more audio profiles 144 based on audio signals. In some embodiments, the profiling module 122 includes one or more machine learning models such as a classification machine learning model that selects one or more classifications corresponding to at least a subset of the one or more audio profiles 144 based on inputs or input parameters including an audio input 136 and/or microphone audio 142, as well as other parameters such as control data and/or audio effects 148. The machine learning model outputs one or more values or classifications indicative at least a subset of the one or more audio profiles 144. In some embodiments, the profiling module 122 includes one or more rules-based models that select one or more classifications corresponding to at least a subset of the one or more audio profiles 144 based on inputs or input parameters including an audio input 136 and/or microphone audio 142, as well as other parameters such as control data and/or audio effects 148. The rules-based model outputs one or more values or classifications indicative at least a subset of the one or more audio profiles 144.

In various embodiments, an audio profiles 144 indicate one or more of a particular genre of a set of genres, a number of beats per minute, a dominant or otherwise characteristic frequency, a dynamic range, a signal to noise ratio, other audio characteristics, and/or the like. In some embodiments, the profiling module 122 stores, in the memory 114, a mapping of audio profiles 144 to audio effects 148 (or modifications to audio effects 148). For example, audio profiles 144 can correspond to and/or be identified based on audio characteristics including, without limitation, frequency range (e.g., bass/mid/treble) balance, clarity, detail, harshness, impact or punch, warmth, muddiness, sound stage width and envelopment, volume based equalization, dynamic equalization, fatiguing characteristics, and/or the like. In some embodiments, the profiling module 122 identifies one or more audio profiles 144 corresponding to the audio signals and provides the one or more audio profiles 144 to the event module 120. In some embodiments, various different audio profiles 144 are identified over various different time frames or durations of time from instantaneous threshold profiles 144 to longer time frame audio profiles 144.

The control data 140 includes any feasible user-specified or user-controlled information that controls the audio produced using the audio system 100. In some embodiments, the control data 140 includes a user-specified volume level, one or more user-specified equalizer parameters, one or more user-specified equalizer parameters, one or more user-specified spatial parameters (e.g., left to right balance, front to back fade, etc.), and/or the like. The control data 140 can also include one or more user-specified audio effects 148.

The microphone audio 142 includes any feasible audio signals detected using a microphone 150. In some embodiments, the microphone audio 142 is temporarily stored in an access memory such as a RAM of the one or more memories 114. In some embodiments, the microphone audio 142 is additionally or alternatively stored in a non-volatile memory of the one or more memories 114.

Each of the one or more microphones 150 can be any technically feasible type of audio input device, such as any type of dynamic, condenser, ribbon, Micro-Electro-Mechanical Systems (MEMS), or other type of microphone. The one or more microphone(s) 150 capture audio including audio signals produced by the one or more speakers 160 of the audio system 100. The captured audio is provided to the audio processing application 118.

Each of the one or more speakers 160 can be any technically feasible type of audio outputting device. Each of the one or more speakers 160 outputs audio that is modified by the audio processing application 118. The one or more speakers 160 produce a sound field based on the audio output 138. The sound field includes one or more audio effects 148 that the audio processing application 118 applies to the audio input 136 to generate the audio output 138.

In one example of operation, the audio system 100 performs audio processing using the audio processing application 118 to include or update audio effects 148 to reduce fatigue in response to high fatigue levels, or increase punch and/or clarity in response to low fatigue levels. The audio processing application 118 receives an audio signal such as an audio input 136 and/or microphone audio 142. In some embodiments, the audio processing application 118 processes the audio signal using the profiling module 122 to identify one or more audio profiles 144 applicable to the audio signal. The audio processing application 118 also processes the audio signal using the event module 120 to identify one or more audio events 146. The audio processing application 118 identifies the audio events 146 based on an overall peak level, one or more frequency-specific peak levels, overall and/or frequency-specific root mean square levels, overall and/or frequency-specific signal to noise ratios, a moving average peak and/or root mean square level, and/or other measures of the audio input 136 in a moving time window or time chunk. The audio processing application 118 maps the one or more audio events 146 to one or more audio effects 148. The audio processing application 118 applies and/or modifies the audio input 136 to include one or more audio effects 148. Accordingly, the audio processing application 118 generates an audio output 138 based on the audio input 136 and the recently identified or updated audio effects 148. In some embodiments, generating the audio output 138 involves incrementally modifying one or more effect parameters of a prior one or more audio effects 148 to the new audio effects 148 over a specified amount of transition time. The audio processing application 118 provides the audio output 138 to the one or more speakers 160 to produce a sound field that includes the audio effects 148.

The audio processing application 118 applies the one or more audio effects 148 to automatically change equalization, dynamics, and other effect parameters over time in response to different types of audio events 146 including fatigue inducing events and/or audio profiles 144. The audio processing application 118 iteratively performs real-time adaptive processing of the audio signals by applying or adjusting one or more audio effects 148 over time. The audio processing application 118 generates an audio output 138 based on the control data 140 and the current audio effects 148. In some embodiments, generating the audio output 138 involves incrementally modifying one or more effect parameters of a prior one or more audio effects 148 to the new audio effects 148 over a specified amount of transition time. The transition time can be instantaneous or any configured period of time.

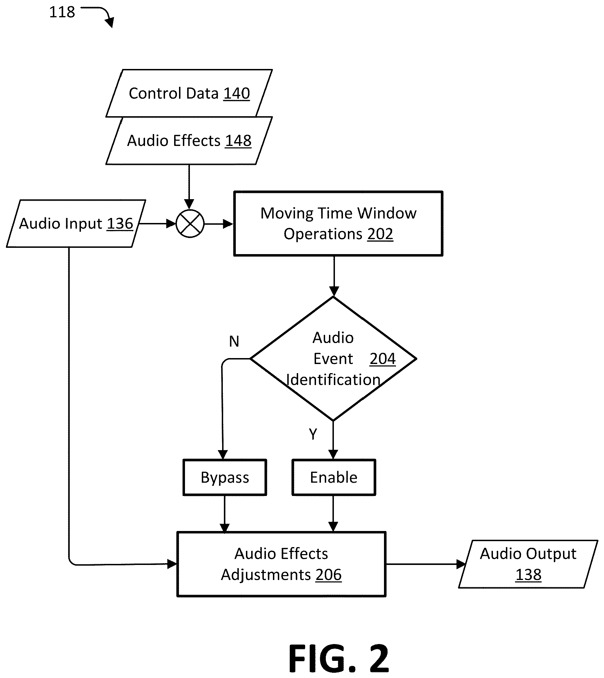

Figure 2 is a diagram illustrating the operation of the audio processing application 118 of Figure 1, according to various embodiments. As shown, audio processing application 118 and/or associated modules includes or performs, without limitation, moving time window operations 202, audio event identification 204, and audio effect adjustments 206. Input data for the audio processing application 118 includes, without limitation, audio input 136, audio effects 148, and control data 140. Output data for the audio processing application 118 includes, without limitation, audio output 138.

In the example of operation shown, the audio processing application 118 uses the audio input 136 to identify audio events 146. The audio processing application 118 multiplies, mixes, or otherwise modifies the audio input 136 based on the control data 140 and the prior audio effects 148 to generate a modified audio input 136. The audio processing application 118 performs one or more moving time window operations 202 on the modified audio input 136. The moving time window operations 202 include processing the modified audio input 136 according to time frames or discrete time segments to identify a running average or other moving or running time window parameter. In various embodiments, the audio processing application 118 performs the moving time window operations 202 identify an overall peak level for all frequencies, one or more frequency-specific peak levels for one or more frequency bins or ranges, overall and/or frequency-specific root mean square levels, overall and/or frequency-specific signal to noise ratios, and other measures of the audio input 136 in a moving time window extending back for a specified time window length from the current time.

The audio processing application 118 performs audio event identification 204, for example, using the event module 120. The audio processing application 118 identifies whether there are any the audio events 146 in a moving time window or time chunk, for example, based on the overall peak level, the one or more frequency-specific peak levels, the overall and/or frequency-specific root mean square levels, the overall and/or frequency-specific signal to noise ratios, the moving average peak and/or root mean square level, and/or other measures of the audio input 136. In various embodiments, the audio processing application 118 identifies fatigue events, brightness events, clarity events, punch events, and/or the like. Each audio event 146 is mapped to one or more audio effects 148. For example, a high fatigue event can be mapped to one or more fatigue reducing effects, while a low fatigue event can be mapped or impact increasing effects (e.g., to increase clarity, punch, brightness and/or the like).

If there are no audio events 146 identified for the time window, then the audio processing application 118 bypasses audio effect adjustments 206 and generates and/or outputs the audio output 138 based on the modified audio input 136, the control data 140, and the prior audio effects 148. However, if one or more audio events 146 are identified for the time window, the audio processing application 118 enables audio effects adjustments 206 and generates and/or outputs the audio output 138 based on the modified audio input 136, the control data 140, the current or new audio effects 148.

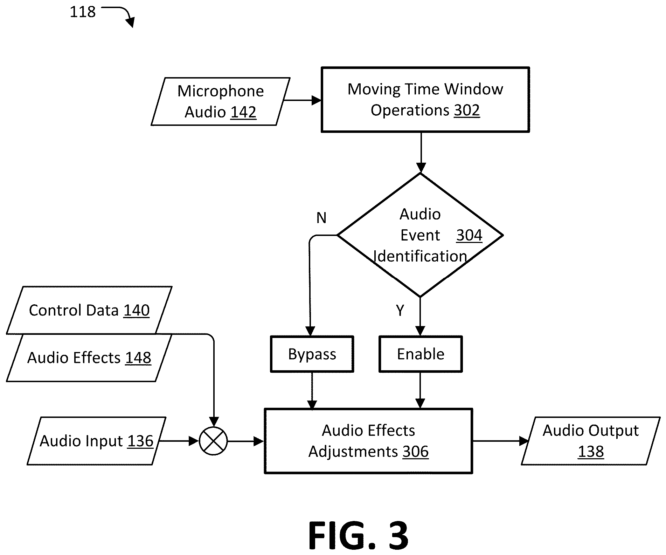

Figure 3 is another diagram illustrating the operation of the audio processing application 118 of Figure 1, according to various embodiments. As shown, audio processing application 118 and/or associated modules includes or performs, without limitation, moving time window operations 302, audio event identification 304, and audio effect adjustments 306. Input data for the audio processing application 118 includes, without limitation, audio input 136, audio effects 148, control data 140, and microphone audio 142. Output data for the audio processing application 118 includes, without limitation, audio output 138.

In the example of operation shown, the audio processing application 118 uses the microphone audio 142 to identify audio events 146. In some embodiments, the audio processing application 118 determines whether microphone audio 142 is available and utilizes the microphone audio 142 in an instance in which the microphone audio 142 is available. The audio processing application 118 performs one or more moving time window operations 302 on the microphone audio 142. The moving time window operations 302 include processing the microphone audio 142 according to time frames or discrete time segments to identify a running average or other moving or running time window parameter. In various embodiments, the audio processing application 118 performs the moving time window operations 302 identify an overall peak level for all frequencies, one or more frequency-specific peak levels for one or more frequency bins or ranges, overall and/or frequency-specific root mean square levels, overall and/or frequency-specific signal to noise ratios, and other measures of the microphone audio 142 in a moving time window extending back for a specified time window length from the current time.

The audio processing application 118 performs audio event identification 304, for example, using the event module 120. The audio processing application 118 identifies whether there are any the audio events 146 in a moving time window or time chunk, for example, based on the overall peak level, the one or more frequency-specific peak levels, the overall and/or frequency-specific root mean square levels, the overall and/or frequency-specific signal to noise ratios, the moving average peak and/or root mean square level, and/or other measures of the audio input 136. In various embodiments, the audio processing application 118 identifies fatigue events, brightness events, clarity events, punch events, and/or the like. Each audio event 146 is mapped to one or more audio effects 148. For example, a high fatigue event can be mapped to one or more fatigue reducing effects, while a low fatigue event can be mapped or impact increasing effects (e.g., to increase clarity, punch, brightness and/or the like).

If there are no audio events 146 identified for the time window, then the audio processing application 118 bypasses audio effects adjustments 306 and generates and/or outputs the audio output 138 based on the control data 140, the prior audio effects 148, and a modified audio input 136. For example, the audio processing application 118 multiplies, mixes, or otherwise modifies the audio input 136 based on the control data 140 and the prior audio effects 148 to generate a modified audio input 136. The audio processing application 118 generates and/or outputs the audio output 138 based on the modified audio input 136, the current control data 140, and the prior audio effects 148.

However, if one or more audio events 146 are identified for the time window, the audio processing application 118 enables audio effect adjustments 306 and generates and/or outputs the audio output 138 based on the control data 140, the current audio effects 148 identified based on the audio events 146 in audio event identification 304.

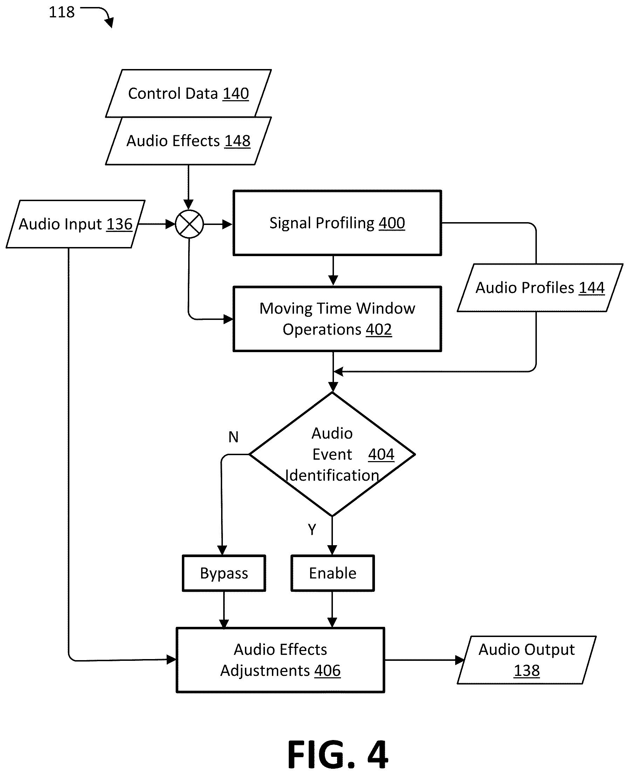

Figure 4 is a diagram illustrating the operation of the audio processing application 118 of Figure 1, according to various embodiments. As shown, audio processing application 118 and/or associated modules includes or performs, without limitation, signal profiling 400, moving time window operations 402, audio event identification 404, and audio effect adjustments 406. Input and intermediate data for the audio processing application 118 includes, without limitation, audio input 136, audio effects 148, control data 140, and audio profiles 144. Output data for the audio processing application 118 includes, without limitation, audio output 138.

In the example of operation shown, the audio processing application 118 uses the audio input 136, control data 140, prior audio effects 148, and audio profiles 144 to identify audio events 146. The audio processing application 118 multiplies, mixes, or otherwise modifies the audio input 136 based on the control data 140 and the prior audio effects 148 to generate a modified audio input 136.

The audio processing application 118 performs signal profiling 400 based on the modified audio input 136. For example, the audio processing application 118 uses the profiling module 122 to identify one or more audio profiles 144 for the audio input 136. In the example shown, the profiling module 122 uses the modified audio input 136 to identify one or more audio profiles 144. However, in other examples, the profiling module 122 uses the unmodified audio input 136 to identify one or more audio profiles 144.

The audio processing application 118 performs one or more moving time window operations 402 on the modified audio input 136. The moving time window operations 402 include processing the modified audio input 136 according to time frames or discrete time segments to identify a running average or other moving or running time window parameter. In various embodiments, the audio processing application 118 performs the moving time window operations 402 identify an overall peak level for all frequencies, one or more frequency-specific peak levels for one or more frequency bins or ranges, overall and/or frequency-specific root mean square levels, overall and/or frequency-specific signal to noise ratios, and other measures of the audio input 136 in a moving time window extending back for a specified time window length from the current time.

The audio processing application 118 performs audio event identification 404, for example, using the event module 120. The audio processing application 118 identifies whether there are any the audio events 146 in the moving time window, for example, based on the overall peak level, the one or more frequency-specific peak levels, the overall and/or frequency-specific root mean square levels, the overall and/or frequency-specific signal to noise ratios, the moving average peak and/or root mean square level, and/or other measures of the audio input 136. In various embodiments, the audio processing application 118 identifies fatigue events, brightness events, clarity events, punch events, and/or the like. In the embodiment shown, the audio processing application 118 identifies whether there are any audio events 146 further based on the audio profiles 144 identified by signal profiling 400. Each audio event 146 is mapped to one or more audio effects 148. For example, a high fatigue event can be mapped to one or more fatigue reducing effects, while a low fatigue event can be mapped or impact increasing effects (e.g., to increase clarity, punch, brightness and/or the like).

If there are no audio events 146 identified for the time window, then the audio processing application 118 bypasses audio effects adjustments 406 and generates and/or outputs the audio output 138 based on the modified audio input 136, the control data 140, and the prior audio effects 148. However, if one or more audio events 146 are identified for the time window, the audio processing application 118 enables audio effects adjustments 406 and generates and/or outputs the audio output 138 based on the modified audio input 136, the control data 140, the current or new audio effects 148.

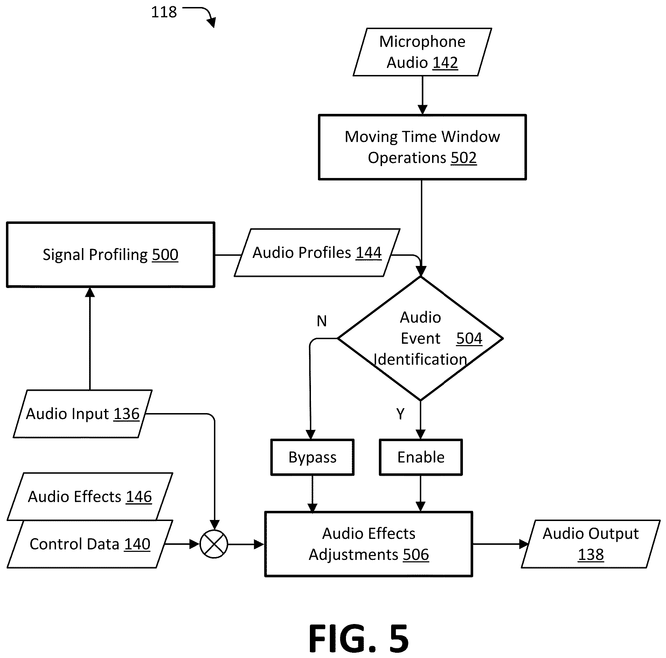

Figure 5 is another diagram illustrating the operation of the audio processing application 118 of Figure 1, according to various embodiments. As shown, audio processing application 118 and/or associated modules includes or performs, without limitation, signal profiling 500, moving time window operations 502, audio event identification 504, and audio effect adjustments 506. Input data and intermediate data for the audio processing application 118 includes, without limitation, audio input 136, audio effects 148, control data 140, microphone audio 142, and audio profiles 144. Output data for the audio processing application 118 includes, without limitation, audio output 138.

In the example of operation shown, the audio processing application 118 uses the microphone audio 142 to identify audio events 146. In some embodiments, the audio processing application 118 determines whether microphone audio 142 is available and utilizes the microphone audio 142 in an instance in which the microphone audio 142 is available.

The audio processing application 118 performs signal profiling 500 based on the audio input 136. For example, the audio processing application 118 uses the profiling module 122 to identify one or more audio profiles 144 for the audio input 136. In the example shown, the profiling module 122 uses the audio input 136 to identify one or more audio profiles 144. However, in other examples, the profiling module 122 uses the modified audio input 136 to identify one or more audio profiles 144.

The audio processing application 118 performs one or more moving time window operations 502 on the microphone audio 142. The moving time window operations 502 include processing the microphone audio 142 according to time frames or discrete time segments to identify a running average or other moving or running time window parameter. In various embodiments, the audio processing application 118 performs the moving time window operations 502 identify an overall peak level for all frequencies, one or more frequency-specific peak levels for one or more frequency bins or ranges, overall and/or frequency-specific root mean square levels, overall and/or frequency-specific signal to noise ratios, and other measures of the microphone audio 142 in a moving time window extending back for a specified time window length from the current time.

The audio processing application 118 performs audio event identification 504, for example, using the event module 120. The audio processing application 118 identifies whether there are any the audio events 146 in a moving time window or time chunk, for example, based on the overall peak level, the one or more frequency-specific peak levels, the overall and/or frequency-specific root mean square levels, the overall and/or frequency-specific signal to noise ratios, the moving average peak and/or root mean square level, and/or other measures of the audio input 136. In various embodiments, the audio processing application 118 identifies fatigue events, brightness events, clarity events, punch events, and/or the like. In the embodiment shown, the audio processing application 118 identifies whether there are any audio events 146 further based on the audio profiles 144 identified by signal profiling 500. Each audio event 146 is mapped to one or more audio effects 148. For example, a high fatigue event can be mapped to one or more fatigue reducing effects, while a low fatigue event can be mapped or impact increasing effects (e.g., to increase clarity, punch, brightness and/or the like).

If there are no audio events 146 identified for the time window, then the audio processing application 118 bypasses audio effect adjustments 506 and generates and/or outputs the audio output 138 based on the control data 140, the prior audio effects 148, and a modified audio input 136. For example, the audio processing application 118 multiplies, mixes, or otherwise modifies the audio input 136 based on the control data 140 and the prior audio effects 148 to generate a modified audio input 136. The audio processing application 118 generates and/or outputs the audio output 138 based on the modified audio input 136, the control data 140, and the prior audio effects 148.

However, if one or more audio events 146 are identified for the time window, the audio processing application 118 enables audio effect adjustments 506 and generates and/or outputs the audio output 138 based on the modified audio input 136, the control data 140, and the current audio effects 148 identified in audio event identification 304.

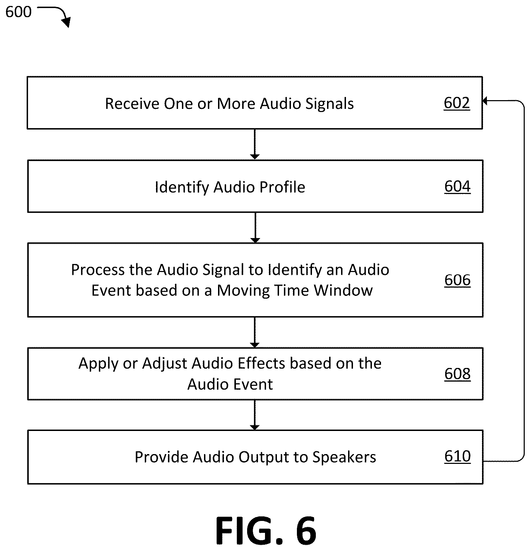

Figure 6 is a flow diagram of method steps for generating audio output based on audio events such as fatigue events, according to various embodiments. Although the method steps are shown in an order, persons skilled in the art will understand that some method steps may be performed in a different order, repeated, omitted, and/or performed by components other than those described in Figure 6. Although the method steps are described with respect to the systems of Figures 1 - 5, persons skilled in the art will understand that any system configured to perform the method steps, in any order, falls within the scope of the various embodiments.

As shown, a method 600 begins at step 602, where the audio processing application 118 receives or identifies one or more audio signals. In various embodiments, the audio signal can include an audio input 136, modified audio input 136, microphone audio 142, and/or a combination thereof. For example, the audio processing application 118 retrieves the audio input 136 from the memory 114 and/or receives the audio input 136 over a network such as a local area network or a wide area network.

At step 604, the audio processing application 118 identifies an audio profile 144 based on an audio signal such as the audio input 136, modified audio input 136, microphone audio 142, and/or a combination thereof. The audio processing application 118 performs signal profiling based on the audio signal. For example, the audio processing application 118 uses the profiling module 122 to identify one or more audio profiles 144. The profiling module 122 includes any executable instructions that identify one or more audio profiles 144 based on audio signals. In some embodiments, the profiling module 122 includes one or more machine learning models and/or one or more rules-based models that select one or more classifications corresponding to at least a subset of the one or more audio profiles 144 based on inputs including an audio input 136 and/or microphone audio 142, as well as other parameters such as control data and/or audio effects 148.

At step 606, the audio processing application 118 processes the audio signal to identify one or more audio events 146 based on a moving time window. The audio processing application 118 performs one or more moving time window operations on the audio input 136 or microphone audio 142. The moving time window operations include processing the audio signal according to time frames or discrete time segments to identify a running average or other moving or running time window parameter. In various embodiments, the audio processing application 118 performs the moving time window operations identify an overall peak level for all frequencies, one or more frequency-specific peak levels for one or more frequency bins or ranges, overall and/or frequency-specific root mean square levels, overall and/or frequency-specific signal to noise ratios, and other measures of the audio signal in a moving time window extending back for a specified time window length from the current time.

At step 608, the audio processing application 118 applies or adjusts one or more audio effects 148 based on the one or more audio events 146. The audio processing application 118 maps each of the one or more audio events 146 to a corresponding one or more audio effects 148. The audio processing application 118 applies the one or more audio effects 148 to automatically change equalization, dynamics, and other effect parameters over time in response to different types of audio events including fatigue inducing events and/or audio profiles 144. The audio processing application 118 iteratively performs real-time adaptive processing of the audio signals by applying or adjusting one or more audio effects 148 over time. The audio processing application 118 generates an audio output 138 based on the control data 140 and the current audio effects 148. In some embodiments, generating the audio output 138 involves incrementally modifying one or more effect parameters of a prior one or more audio effects 148 to the new audio effects 148 over a specified amount of transition time.

At step 610, the audio processing application 118 provides the audio output 138 to the one or more speakers 160. The speakers 160 produce a sound field that includes the audio effects 148. As a result, the audio processing application 118 provides adaptive modification of audio fields to provide a safe and healthy listening experience. The adaptive modification of audio fields maintains short term punch and other impact effects, providing greater accessibility while maintaining long term safety, and/or sound reproduction optimization that adapts to the audio input 136. As a result, the audio processing application 118 adaptively optimizes or otherwise modifies the listening experience over time based on the audio input 136.

In sum, techniques are disclosed for audio processing, and more specifically, to equalizing audio to prevent or alleviate fatigue or adaptively optimize the listening experience based on audio inputs. The described techniques involve adaptive modification of audio fields, ensuring that the audio systems produce the desired effects while preventing fatigue while enabling or maximizing short term impact such as punch, clarity, and brightness. The described techniques are also iteratively performed over time to enable real-time adaptive processing. The described techniques include receiving an audio signal, analyzing the audio signal over a moving time window to determine audio events such as fatigue events, applying audio effects based on the audio events, and outputting an audio output to using one or more speakers produce a sound field that includes the audio effects.

At least one technical advantage of the disclosed techniques relative to the prior art is that the disclosed techniques enable adaptive modification of audio fields to provide a safe and healthy listening experience while maintaining short term punch, thus providing greater accessibility. The disclosed techniques allow for an audio system to automatically change equalization, dynamics, and other audio processing effects over time in response to different types of events, such as fatigue inducing events. These technical advantages represent one or more technological improvements over prior art approaches.
1. In some embodiments, a computer-implemented method comprises processing an audio input to identify an audio event based on a moving time window of the audio input, determining one or more audio effects based on the audio event, generating an audio output by applying the one or more audio effects to the audio input, and providing the audio output to one or more speakers.
2. The computer-implemented method of clause 1, further comprising retrieving the audio input from a memory, or receiving the audio input over a network.
3. The computer-implemented method of clauses 1 or 2, further comprising identifying an audio profile of the audio input.
4. The computer-implemented method of any of clauses 1-3, wherein identifying the audio profile comprises providing the audio input as an input parameter to a machine learning model that outputs at least one value associated with the audio profile.
5. The computer-implemented method of any of clauses 1-4, wherein identifying the audio profile comprises providing the audio input as an input parameter to a rules-based model that outputs at least one value associated with the audio profile.
6. The computer-implemented method of any of clauses 1-5, wherein the audio event corresponds to a fatigue event that is identified based on the audio profile and a running average value for the moving time window.
7. The computer-implemented method of any of clauses 1-6, wherein the audio profile indicates at least one of a genre, a number of beats per minute, a frequency, frequency range balance, a clarity characteristic, a detail characteristic, a harshness characteristic, a punch characteristic, a warmth characteristic, a muddiness characteristic, a sound stage width, a sound stage envelopment, a volume based equalization, a dynamic equalization, a fatiguing characteristic, a dynamic range, or a signal to noise ratio of the audio input.
8. The computer-implemented method of any of clauses 1-7, wherein the audio event is identified based on the moving time window and audio system control data.
9. The computer-implemented method of any of clauses 1-8, wherein applying the one or more audio effects comprises at least one of modifying at least one equalizer value, performing dynamics processing, or performing volume processing.
10. The computer-implemented method of any of clauses 1-9, wherein identifying the audio event comprises comparing a running average value for the moving time window to at least one loudness level threshold value.
11. In some embodiments, one or more non-transitory computer-readable media store instructions that, when executed by one or more processors, cause the one or more processors to perform the steps of processing an audio signal to identify an audio event based on a moving time window of an audio input, determining one or more audio effects based on the audio event, applying the one or more audio effects to the audio input to generate an audio output, and producing a sound field based on the audio output.
12. The one or more non-transitory computer-readable media of clause 11, wherein the audio signal comprises the audio input or microphone audio detected using a microphone device.
13. The one or more non-transitory computer-readable media of clauses 11 or 12, wherein the one or more processors execute the instructions to perform the further steps of retrieving the audio input from a memory, or receiving the audio input over a network comprising at least one of a local area network or a wide area network.
14. The one or more non-transitory computer-readable media of any of clauses 11-13, wherein the one or more processors execute the instructions to perform the steps of identifying an audio profile of the audio input.
15. The one or more non-transitory computer-readable media of any of clauses 11-14, wherein identifying the audio profile comprises processing the audio input using a machine learning model that identifies the audio profile.
16. The one or more non-transitory computer-readable media of any of clauses 11-15, wherein identifying the audio profile comprises processing the audio input using a rules-based model that identifies the audio profile.
17. The one or more non-transitory computer-readable media of any of clauses 11-16, wherein the audio event is a fatigue event.
18. The one or more non-transitory computer-readable media of any of clauses 11-17, wherein the audio profile indicates at least one of a genre, a number of beats per minute, a frequency, a dynamic range, or a signal to noise ratio of the audio input.
19. The one or more non-transitory computer-readable media of any of clauses 11-18, wherein the audio event is identified based on the moving time window and audio system control data.
20. In some embodiments, a system comprises one or more speakers, a memory storing instructions, and one or more processors, that when executing the instructions, are configured to perform the steps of processing a moving time window of an audio input to identify one or more audio events, determining one or more audio effects based on the one or more audio events, generating an audio output by applying the one or more audio effects to the audio input, and producing a sound field based on the audio output.

The descriptions of the various embodiments have been presented for purposes of illustration, but are not intended to be exhaustive or limited to the embodiments disclosed. Many modifications and variations will be apparent to those of ordinary skill in the art without departing from the scope and spirit of the described embodiments.

Aspects of the present embodiments may be embodied as a system, method, or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "module" or "system." Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, enable the implementation of the functions/acts specified in the flowchart and/or block diagram block or blocks. Such processors may be, without limitation, general purpose processors, special-purpose processors, application-specific processors, or field-programmable processors or gate arrays.

Flowcharts and block diagrams in the figures illustrate the architecture, functionality, and operation of possible implementations of systems, methods, and computer program products according to various embodiments of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure may be devised without departing from the basic scope thereof, and the scope thereof is determined by the claims that follow.

## Claims

1. A computer-implemented method, comprising:
processing an audio input to identify an audio event based on a moving time window of the audio input;
determining one or more audio effects based on the audio event;
generating an audio output by applying the one or more audio effects to the audio input; and providing the audio output to one or more speakers.

2. The computer-implemented method of claim 1, further comprising:
retrieving the audio input from a memory; or
receiving the audio input over a network.

3. The computer-implemented method of claim 1 or 2, further comprising:
identifying an audio profile of the audio input.

4. The computer-implemented method of claim 3, wherein identifying the audio profile comprises providing the audio input as an input parameter to a machine learning model that outputs at least one value associated with the audio profile.

5. The computer-implemented method of claim 3 or 4, wherein identifying the audio profile comprises providing the audio input as an input parameter to a rules-based model that outputs at least one value associated with the audio profile.

6. The computer-implemented method of any of claims 3 to 5, wherein the audio event corresponds to a fatigue event that is identified based on the audio profile and a running average value for the moving time window.

7. The computer-implemented method of any of claims 3 to 6, wherein the audio profile indicates at least one of a genre, a number of beats per minute, a frequency, frequency range balance, a clarity characteristic, a detail characteristic, a harshness characteristic, a punch characteristic, a warmth characteristic, a muddiness characteristic, a sound stage width, a sound stage envelopment, a volume based equalization, a dynamic equalization, a fatiguing characteristic, a dynamic range, or a signal to noise ratio of the audio input.

8. The computer-implemented method of any preceding claim, wherein the audio event is identified based on the moving time window and audio system control data.

9. The computer-implemented method of any preceding claim, wherein applying the one or more audio effects comprises at least one of: modifying at least one equalizer value, performing dynamics processing, or performing volume processing.

10. The computer-implemented method of any preceding claim, wherein identifying the audio event comprises comparing a running average value for the moving time window to at least one loudness level threshold value.

11. One or more non-transitory computer-readable media storing instructions that, when executed by one or more processors, cause the one or more processors to perform the steps of:
processing an audio signal to identify an audio event based on a moving time window of an audio input;
determining one or more audio effects based on the audio event;
applying the one or more audio effects to the audio input to generate an audio output; and producing a sound field based on the audio output.

12. The one or more non-transitory computer-readable media of claim 11, wherein the audio signal comprises the audio input or microphone audio detected using a microphone device.

13. The one or more non-transitory computer-readable media of claim 11 or 12, wherein the one or more processors execute the instructions to perform the further steps of:
retrieving the audio input from a memory; or
receiving the audio input over a network comprising at least one of a local area network or a wide area network.

14. The one or more non-transitory computer-readable media of any of claims 11 to 13, wherein the one or more processors execute the instructions to perform the steps of:
identifying an audio profile of the audio input.

15. A system comprising:
one or more speakers;
a memory storing instructions; and
one or more processors, that when executing the instructions, are configured to perform the steps of:
processing a moving time window of an audio input to identify one or more audio events;
determining one or more audio effects based on the one or more audio events;
generating an audio output by applying the one or more audio effects to the audio input; and
producing a sound field based on the audio output.
